# EUROPÄISCHE PATENTSCHRIFT

(11) **EP 4 369 017 B1**
(45) Veröffentlichungstag und Bekanntmachung des Hinweises auf die Patenterteilung: **02.07.2025**
(21) Anmeldenummer: 22206849.6
(22) Anmeldetag: 11.11.2022
(51) Int. Cl.: G01R 33/28, G01R 33/565, G01R 33/389

(54) **MAGNETRESONANZTOMOGRAPH UND VERFAHREN ZUR REDUKTION VON BILDSTÖRUNGEN DURCH NIEDERFREQUENTE MAGNETFELDER**
MAGNETIC RESONANCE TOMOGRAPH AND METHOD FOR REDUCING IMAGE INTERFERENCE BY LOW-FREQUENCY MAGNETIC FIELDS
APPAREIL D'IMAGERIE PAR RÉSONANCE MAGNÉTIQUE ET PROCÉDÉ DE RÉDUCTION DE PERTURBATIONS D'IMAGE PAR DES CHAMPS MAGNÉTIQUES BASSE FRÉQUENCE

(43) Veröffentlichungstag der Anmeldung: 15.05.2024
(73) Patentinhaber: Siemens Healthineers AG, 91301 Forchheim (DE)
(72) Erfinder: Dewdney, Andrew, 91077 Neunkirchen am Brand (DE)
(74) Vertreter: Siemens Healthineers Patent Attorneys

(56) Entgegenhaltungen:
- DE-A1- 102009 021 026
- JP-A- H0 467 848
- JP-A- H06 181 903
- LIU CHAO ET AL: "Effect of magnetic field fluctuation on ultra-low field MRI measurements in the unshielded laboratory environment", JOURNAL OF MAGNETIC RESONANCE., vol. 257, August 2015 (2015-08-01), US, pages 8 - 14, XP093035753, ISSN: 1090-7807, DOI: 10.1016/j.jmr.2015.04.014
- ERTAN K. ET AL.: "Spatiotemporal Magnetic Field Monitoring with Hall Effect Sensors", PROCEEDINGS OF THE INTERNATIONAL SOCIETY FOR MAGNETIC RESONANCE IN MEDICINE, ISMRM, 2030 ADDISON STREET, 7TH FLOOR, BERKELEY, CA 94704 USA, no. 3910, 7 April 2017 (2017-04-07), Hi, USA, XP040691478

## Beschreibung

Unabhängig vom grammatikalischen Geschlecht eines bestimmten Begriffes sind Personen mit männlicher, weiblicher oder anderer Geschlechteridentität mit umfasst.

Die Erfindung betrifft einen Magnetresonanztomographen mit einem Magnetfeldsensor und ein Verfahren zum Reduzieren von Störungen durch externe Magnetfelder.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden.

Trotz der hohen Magnetfelder ist die Bilderfassung mit dem Magnetresonanztomographen empfindlich gegen Variationen des statischen bzw. quasistatischen B0-Magnetfeldes, da die Bandbreite der Empfangssysteme begrenzt ist. Darüber hinaus ist es häufig erforderlich, Protonen in Wasser von Protonen im Fett zu unterscheiden, um die unterschiedlichen Gewebearten getrennt abbilden zu können. Wegen des geringen Einflusses der chemischen Bindungen auf die Atomkerne sind hier die Unterschiede der magnetischen Momente und daraus resultierend die Frequenzunterschiede der Magnetresonanzsignale sehr gering, was zu der hohen Sensibilität für Abweichungen des statischen Magnetfeldes führt.

Aus dem Dokument JP H06 181903 A ist ein Magnetresonanztomographiegerät mit Permanentmagneten bekannt. Das Magnetresonanztomographiegerät ist mit einem ersten Magnetfeldsensor und einem zweiten Magnetfeldsensor versehen, die entfernt vom Gerät angeordnet sind, und einer ersten Korrekturmagnetfeldspule und einer zweiten Korrekturmagnetfeldspule, die das Magnetfeld im Messraum basierend auf der Erkennung der Magnetfeldschwankung durch den ersten und den zweiten Magnetfeldsensor korrigieren.

Es ist daher eine Aufgabe der vorliegenden Erfindung, die Abbildungseigenschaften des Magnetresonanztomographen zu verbessern.

Die Aufgabe wird durch einen erfindungsgemäßen Magnetresonanztomographen nach Anspruch 1 und ein erfindungsgemäßes Verfahren nach Anspruch 5 gelöst.

Der erfindungsgemäße Magnetresonanztomograph weist eine Steuerung auf. Unter Steuerung wird ein Rechner oder Controller verstanden, der in dem Magnetresonanztomographen bei einer Bilderfassung den Ablauf einer Sequenz steuert, insbesondere die zeitliche Koordination und Signale für die Gradienten, aber auch die Hochfrequenzaussendung und Empfang. Der erfindungsgemäße Magnetresonanztomograph weist weiterhin eine Mehrzahl an Magnetfeldsensoren auf. Unter Magnetfeldsensor wird ein Sensor verstanden, der die Stärke zumindest einer Magnetfeldkomponente bzw. räumlichen Komponente eines Magnetfeldes bzw. des Magnetfeldvektors erfassen kann. Das zu erfassende Magnetfeld hat dabei eine Magnetfeldstärke, die kleiner ist als die des statischen Magnetfeldes B0, beispielsweise kleiner als 0,1T, 10 mT, 1 mT oder 100 Mikrotesla. Insbesondere ist die Auflösung des Magnetfeldsensors besser als 100 Mikrotesla oder 1 Mikrotesla. Der Magnetfeldsensor weist dabei eine zeitliche Auflösung kleiner als 100 Hz, 10Hz 1 Hz oder 0,1 Hz auf. Die störenden niederfrequenten Magnetfelder können beispielsweise von vorbeifahrenden Straßenbahnen, Zügen oder anderen Elektrofahrzeugen verursacht werden. Mögliche Quellen können auch Elektromotore in Aufzügen oder Maschinen sein.

Die Magnetfeldsensoren sind in einer Umgebung des Magnetresonanztomographen angeordnet. Unter Umgebung wird ein Bereich außerhalb eines Magnetresonanztomographen angesehen oder zumindest an einer Innenseite eines Gehäuses des Magnetresonanztomographen. Vorzugsweise sind die Magnetfeldsensoren so bzw. so weit entfernt von dem Magnetresonanztomographen angeordnet, dass die Magnetfeldsensoren nicht durch das statische Magnetfeld des Feldmagneten in Sättigung gesteuert wird und noch externe störende Magnetfelder detektieren kann, beispielsweise in einem Abstand größer als 1 m oder 2 m. Vorzugsweise sind die Magnetfeldsensoren innerhalb des Raumes angeordnet, in dem sich der Magnetresonanztomograph bzw. der Feldmagnet befindet.

Die Magnetfeldsensoren stehen über eine Signalverbindung mit der Steuerung in Verbindung und können dieser Information über das erfasste Magnetfeld übermitteln, proaktiv oder auf Abfrage/Polling. Die Signalverbindung kann analog oder digital sein, über elektrisch leitende Kabel, optische Kabel oder auch drahtlos sein, beispielsweise mittels WLAN, Bluetooth oder einer anderen Funktechnik.

Auf vorteilhafte Weise kann der Magnetresonanztomograph mittels der Magnetfeldsensoren störende Magnetfelder erkennen und mittels der Steuerung, wie nachfolgend zum Verfahren und in den Unteransprüchen angegeben, anhand dieser Information die störenden Magnetfelder kompensieren.

Im Übrigen ist der erfindungsgemäße Magnetresonanztomograph ausgebildet, das nachfolgend beschriebene Verfahren auszuführen.

Das erfindungsgemäße Verfahren weist den Schritt auf, ein störendes Magnetfeld bzw. Störfeld in einer Umgebung des Magnetresonanztomographen mit den Magnetfeldsensoren durch die Steuerung mittels der Magnetfeldsensoren zu erfassen. Dabei wird ein Betrag oder eine Stärke zumindest einer Magnetfeldkomponente an einer Mehrzahl von Punkten im Raum um den Magnetresonanztomographen erfasst. Die Magnetfeldsensoren umgeben dabei vorzugsweise den Magnetresonanztomographen derart, dass die Magnetfeldsensoren an Eckpunkten eines Polyeders liegen, von dem der Magnetresonanztomograph umgeben ist. Denkbar ist auch, dass der Polyeder Öffnungen in Richtungen aufweist, in die keine veränderliche Quelle zu erwarten ist. Ist das Magnetfeld auf einer Oberfläche um den Magnetresonanztomograph bekannt, kann auf vorteilhafte Weise aufgrund der Feldgleichungen für Magnetfelder das Magnetfeld im Inneren (unter Berücksichtigung von bekannten Quellen im Inneren) und damit auch im Bilderfassungsbereich bestimmt werden. Dies ist auch unter dem Stichwort Huygens-Box bekannt.

Das Erfassen kann dabei auch in kontinuierlich oder in vorbestimmten Intervallen erfolgen. Das Erfassen kann weiterhin eine Vorbearbeitung einschließen. Denkbar ist beispielsweise ein Filtern oder Vorverzerren, um eine Zeitbeziehungsweise Frequenzabhängigkeit der Sensoren oder Transferfunktion des Magnetfelds zwischen dem Sensor und dem Bilderfassungsbereich zu berücksichtigen. So werden beispielsweise magnetische Wechselfelder mit höherer Frequenz durch Wirbelströme in metallischen Teilen des Magnetresonanztomographen stärker abgeschwächt.

Ist dem Magnetresonanztomographen bzw. dessen Steuerung erst einmal das störende Magnetfeld im Bilderfassungsbereich bekannt, kann es gemäß dem erfindungsgemäßen Verfahren auf unterschiedliche Weise in seiner Auswirkung auf das zu erzeugende Bild kompensiert werden.

Zum einen können gemäß einer Ausführungsform die Auswirkungen dieses störenden Magnetfeldes auf die Magnetresonanzdaten kompensiert bzw. bei der Rekonstruktion berücksichtigt werden. Ein in erster Näherung im Bilderfassungsbereich homogenes störendes Magnetfeld führt zu einer Verschiebung der Larmorfrequenz bzw. deren Mittenfrequenz. In einem Schritt des Verfahrens wird diese Mittenfrequenz bzw. deren Verschiebung in Abhängigkeit von dem störenden Magnetfeld ermittelt.

Die Magnetresonanzdaten für die Bilderfassung werden dann in einem weiteren Schritt in Abhängigkeit von dieser Mittenfrequenz erfasst. Im Empfangspfad ist ein frequenzvariabler Oszillator, z.B. ein NCO (numerically controlled oscillator) zum Heruntermischen des Magnetresonanzsignals auf eine Zwischenfrequenz vorgesehen. Die Steuerung stellt den frequenzvariablen Oszillator in Abhängigkeit von der ermittelten Mittenfrequenz bzw. dem störenden Magnetfeld im Bilderfassungsbereich so ein, dass das heruntergemischte Magnetresonanzsignal eine konstante Mittenfrequenz aufweist und so der Effekt des störenden Magnetfeldes kompensiert wird.

Auf vorteilhafte Weise erfordert das erfindungsgemäße Verfahren keine konstruktiven Änderungen zur Erzeugung eines Kompensationsfeldes sowie keinen zusätzlichen Energiebedarf zu deren Erzeugung.

In einer anderen Ausführungsform des erfindungsgemäßen Verfahrens hingegen ist vorgesehen, die Auswirkungen des störenden Magnetfeldes bereits vor der Erfassung der Magnetresonanzdaten zumindest teilweise zu kompensieren, indem es durch ein Kompensationsmagnetfeld aufgehoben wird.

Dazu wird in einem Schritt ein quasistatisches Kompensationsmagnetfeld und/oder Gradientenfeld-Offset in Abhängigkeit von dem erfassten Magnetfeld ermittelt, das für eine Bilderfassung das erfasste störende Magnetfeld ganz oder teilweise kompensiert. Das Kompensationsmagnetfeld ist idealerweise ein vom Betrag identisches Feld zu dem störenden Magnetfeld im Bilderfassungsbereich, aber mit umgekehrter Polarität.

Bei Quellen in einer Ebene mit dem Magnetresonanztomographen ist entsprechend das Ermitteln über bekannte Werte an einer Umrandung des Magnetresonanztomographen in der Ebene möglich. Das gilt auch für das Ermitteln der Mittenfrequenz. Anschließend wird von der Steuerung das ermittelte statische Magnetfeld und/oder der Gradientenfeld-Offset durch die Steuerung ausgegeben. Denkbar sind beispielsweise separate Kompensationsspulen. Denkbar wären beispielsweise für eine oder alle Raumrichtungen Helmholtz-Spulenpaare. Auch können die Gradientenspulen bei Ansteuerung mit einem Strom, der parallele und gleichgerichtete Magnetfelder in beiden Spulen eines Gradientenspulenpaares erzeugt, auch als Gradientenfeld-Offset bezeichnet, entsprechende Kompensationsfelder erzeugt werden.

In einem weiteren Schritt werden unter Anwesenheit der Kompensationsfelder Magnetresonanzdaten für eine Bildgebung erfasst, mit den bekannten Sequenzen, auch unter Anwendung von Verfahren wie Fettsättigung.

Denkbar sind auch zeitlich begrenzte Kompensationsfelder, die wiederum in ihrer Stärke so verändert sind, dass die integrale Wirkung auf eine Teilsequenz äquivalent ist.

In dieser Ausführungsform ist die Kompensation auf vorteilhafte Weise transparent für die Bildrekonstruktion, sodass hier keine Änderungen erforderlich sind.

Vorzugsweise wird aus den erfassten Magnetresonanzdaten eine Abbildung rekonstruiert. Wie bereits ausgeführt, kann die Rekonstruktion in einer Ausführungsform auch in Abhängigkeit von den durch die Magnetsensoren erfassten störendem Magnetfeld erfolgen, um dessen Wirkung in der Abbildung zu kompensieren. Denkbar ist es, dass Werte zu dem störenden Magnetfeld mit den Magnetresonanzdaten gespeichert werden. Die Rekonstruktion kann auf der Steuerung des Magnetresonanztomographen ausgeführt werden, aber auch von einem dedizierten Rekonstruktionsrechner als Teil des Magnetresonanztomographen oder auf einer abgesetzten Ressource wie einem Server oder als Cloud-Ressource. Abschließend wird die Abbildung einem Nutzer auf einem Display ausgegeben, beispielsweise am Magnetresonanztomograph selbst oder einem Befundungs-Arbeitplatz.

Insesondere ist auch denkbar, die beiden Ausführungsformen auf vorteilhafte Weise zu kombinieren. Beispielsweise kann der frequenzvariable Oszillator vorzugsweise über die erfassten Magnetresonanzdaten konstante Mittenfrequenzverschiebungen kompensieren. Ein Gradient des störenden Magnetfeldes hingegen würde eine ortsabhängige Änderung der Mittenfrequenz erfordern. Der Gradient des störenden Magnetfeldes kann wiederum durch eine Variation des von den Gradientenspulen erzeugten Feldgradienten kompensiert werden. Auf vorteilhafte Weise werden die meist stärkeren Anteile nullter Ordnung so ohne zusätzlichen Energieaufwand durch die Mittenfrequenz kompensiert, während die schwächeren Anteile erster und höherer Ordnung mit vertretbarem Energieaufwand durch erzeugte Kompensations-Magnetfelder behoben werden.

Auf vorteilhafte Weise ermöglichen das erfindungsgemäße Verfahren mit dem erfindungsgemäßen Magnetresonanztomographen eine vollständige oder zumindest teilweise Kompensation von niederfrequenten magnetischen Störfeldern.

Weitere vorteilhafte Ausführungsformen sind zu den Unteransprüchen angegeben.

In einer möglichen Ausführungsform des erfindungsgemäßen Magnetresonanztomographen ist die Steuerung ausgelegt, ein quasistatisches Magnetfeld und/oder ein Gradientenfeld bei einer Bilderfassung in Abhängigkeit von der Information zu den Magnetfeldern zu verändern, sodass ein Einfluss des erfassten Magnetfeldes auf die Bilderfassung reduziert wird. Mit anderen Worten, die Steuerung ist vorteilhafter Weise ausgelegt, das bereits beschriebene erfindungsgemäße Verfahren durch das Ermitteln und Ausgeben eines Kompensationsfeldes anhand der mit den Magnetfeldsensoren erfassten Magnetfelder umzusetzen und Auswirkungen eines externen Störfeldes zu reduzieren. Als quasistatisches Magnetfeld wird hierbei ein Magnetfeld bezeichnet, dass in Abgrenzung zu einem für eine Messung konstanten Magnetfeld B0 des supraleitenden Magneten in einer Zeitskale mit dem von den Magnetfeldsensoren erfassten Magnetfeld ändert, aber auch um Größenordnungen niedrigeren Frequenz als die Larmorfrequenz des B1 Feldes der Kernspins.

In einer denkbaren Ausführungsform des erfindungsgemäßen Magnetresonanztomographen weisen die Magnetfeldsensoren einen Halbleitersensor auf. Denkbar sind beispielsweise Hallsensoren.

Auf vorteilhafte Weise ermöglichen die Halbleitersensoren die Bereitstellung kleiner, kostengünstiger und robuster Magnetfeldsensoren.

In einer möglichen Ausführungsform des erfindungsgemäßen Magnetresonanztomographen sind die Magnetfeldsensoren ausgelegt, eine Magnetfeldrichtung eines störenden Magnetfeldes zu erfassen. Denkbar ist beispielsweise die Kombination dreier Magnetfeldsensoren wie **z.B.** Hallsensoren, die jeweils eine Stärke einer Komponente senkrecht zur flächigen Ausrichtung des Halbleiters erfassen. Die drei Sensoren sind vorzugsweise orthogonal zueinander ausgerichtet, sodass alle drei Komponenten des Magnetfeldes erfasst und dieses dadurch vollständig definiert ist. Es ist aber auch denkbar, einzelne Sensoren an unterschiedlichen Orten mit unterschiedlichen Sensitivitätsrichtungen zu kombinieren, um das Magnetfeld zu erfassen. Dies ist besonders denkbar, wenn die Quelle des störenden Magnetfeldes weiter entfernt ist und somit eine räumliche Variation am Ort des Magnetresonanztomographen gering ist.

Auf vorteilhafte Weise ermöglicht eine vollständige räumliche Erfassung des störenden Magnetfeldes eine bessere Kompensation.

In einer denkbaren Ausführungsform des erfindungsgemäßen Verfahrens weist das Verfahren weiterhin den Schritt auf, ein vorbestimmtes magnetisches Kalibrierfeldes mittels einer Kalibrierquelle auszugeben. Die Kalibrierquelle kann hier beispielsweise eine wohldefinierte Gleichstromquelle oder eine Quelle für einen niederfrequenten Wechselstrom sein mit einer Frequenz z.B. kleiner als 100 Hz, 10Hz 1 Hz oder 0,1 Hz, die einen Strom durch eine Kalibrierspule leitet und auf diese Weise ein Magnetfeld erzeugt. Vorzugsweise ist das Magnetfeld der Spule für einen bekannten Strom, der durch die Kalibrierspule fließt, wohlbekannt. Denkbar wäre beispielsweise eine ringförmige Kalibrierspule, für die das Magnetfeld mittels des Biot-Savart-Gesetztes analytisch berechenbar ist. Mit einer bekannten Position und Ausrichtung der Kalibrierspule ist dann das von der Kalibrierspule erzeugte Magnetfeld bekannt, zumindest am Ort der Kalibrierspule und in einer freien Umgebung davon, insbesondere am Ort der Magnetfeldsensoren in einer Umgebung der Kalibrierspule.

In einem weiteren Schritt wird das magnetischen Kalibrierfeld mit den Magnetfeldsensoren in einer Umgebung des Magnetresonanztomographen erfasst. Auf diese Weise kann der Magnetfeldsensor anhand des bekannten magnetischen Kalibrierfeldes kalibriert werden, d.h. eine Funktion als Zusammenhang zwischen Signal des Sensors und dem Magnetfeld am Ort des Sensors ermittelt werden.

In einem anderen Schritt wird das magnetischen Kalibrierfeld in einem Bilderfassungsbereich mittels einer Kalibriersequenz erfasst. Denkbar sind hier beispielsweise auch Sequenzen, wie sie zur Erfassung der "GIRF" (Gradient Impulse Response Functions, beschrieben z.B in "Signe Johanna Vannesjo et. al. GIRF Gradient system characterization by impulse response measurements with a dynamic field camera, February 2013 Magnetic Resonance in Medicine 69(2)") bekannt sind. Damit lässt sich ein zeitlicher Verlauf bzw. eine Frequenz- und/oder Zeitabhängigkeit der Transferfunktion erfassen. Daraus lässt sich als erste Transferfunktion ein funktionaler Zusammenhang, wahlweise auch Zeit- bzw. Frequenz-abhängig, zwischen dem Kalibrierfeld und den davon verursachten Abweichungen im Bilderfassungsbereich bestimmen. Diese Messung wird vorzugsweise mit unterschiedlichen Kalibrierfeldern wiederholt. Die Magnetfelder können sich dabei in Richtung und/oder Stärke unterscheiden. Insbesondere wenn die Anzahl der unterschiedlichen Messungen größer oder gleich der Anzahl der verwendeten Magnetfeldsensoren ist, lässt sich ein eindeutiger und umkehrbarer funktionaler Zusammenhang bestimmen.

Diese erste Transferfunktionen wird in dem Schritt Ermitteln eines statischen Magnetfeldes und/oder Gradientenfeld-Offsets genutzt, beispielsweise, indem das störende Magnetfeld im Bilderfassungsbereich bzw. FoV mit dieser ersten Transferfunktion aus den Messwerten der Magnetfeldsensoren ermittelt wird.

Die erste Transferfunktion kann auch in einer Ausführungsform genutzt werden, um die Mittenfrequenz bzw. deren Verschiebung durch das störende Magnetfeld zu ermitteln.

Somit kann auf vorteilhafte Weise das störende Magnetfeld im FoV aus den Messwerten der Magnetfeldsensoren und damit das erforderliche Kompensationsfeld bzw. die Verschiebung der Mittenfrequenz genauer und einfacher ermittelt werden.

In einer möglichen Ausführungsform des erfindungsgemäßen Verfahrens weist das Verfahren weiterhin den Schritt auf, ein vorbestimmtes Magnetfeld und/oder einen Gradientenfeld-Offset durch die Steuerung auszugeben. Beispielsweise können eine oder mehrere der Gradientenspulen oder eine oder mehrere Kompensationsspulen mit einem vorbestimmten Kalibrierstrom beaufschlagt werden. Der Kalibrierstrom kann ein Gleichstrom oder ein niederfrequenter Wechselstrom sein. Vorzugsweise hängt der zeitliche Verlauf des Wechselstroms von dem erfassten zeitlichen Verlauf des magnetischen Störfeldes ab, beispielsweise weisen beide ähnlichen Frequenzen bzw. ein ähnliches Frequenzspektrum auf.

In einem weiteren Schritt wird, wie bereits zuvor beschrieben, das von dem Kalibrierstrom mit der bzw. den Kompensationsspulen oder Gradientenspulen erzeugte Magnetfeld in einem Bilderfassungsbereich mittels einer Kalibriersequenz erfasst. Diese Messung wird vorzugsweise mit unterschiedlichen Kalibrierströmen wiederholt. Insbesondere wenn die Anzahl der unterschiedlichen Messungen größer oder gleich der Anzahl der verwendeten Kompensationsspulen bzw. Gradientenspulen ist, lässt sich ein eindeutiger und umkehrbarer funktionaler Zusammenhang bestimmen. Auf diese Weise wird ein funktionaler Zusammenhang bzw. eine zweite Transferfunktion zwischen den von der Steuerung ausgegebenen bzw. eingestellten Strömen durch Gradienten- bzw. Kompensationsspule und dem davon im Bilderfassungsbereich/FoV erzeugten Magnetfeld ermittelt.

In dem Schritt Ermitteln eines statischen bzw. niederfrequenten Magnetfeldes und/oder Gradientenfeld-Offsets erfolgt dann das Ermitteln in Abhängigkeit von der zweiten Transferfunktion. Beispielsweise kann mittels der ersten Transferfunktion aus den Messwerten der Magnetfeldsensoren das störende Magnetfeld im Bilderfassungsbereich bestimmt werden. Ein Magnetfeld zur Kompensation des störenden Magnetfeldes muss dann gleiche Stärke und umgekehrte Richtung aufweisen. Mittels einer Umkehrfunktion der zweiten Transferfunktion lassen sich daraus wieder die erforderlichen Ströme ermitteln, mit der die Kompensationsspule(en) bzw. Gradientenspule(en) beaufschlagt werden müssen. Die Umkehrfunktion kann dabei auch durch numerische Verfahren ermittelt werden.

Da die Bilderfassung vor allem sensibel auf die Stärke des Magnetfeldes, weniger aber auf die Richtung ist, ist es auch denkbar, dass die Magnetfeldsensoren und daraus resultierend die Transferfunktionen das störende Magnetfeld nicht vollständig in allen Komponenten abbilden, sondern eine kleinere Dimensionalität aufweisen, als dafür erforderlich wäre.

Vorteilhafter Weise können durch die zweite Transferfunktion bzw. deren Umkehrfunktion schneller die erforderlichen Korrekturströme ermittelt werden und so die obere Grenzfrequenz der Kompensation verbessert werden.

Grundsätzlich wäre es auch denkbar, dass die erste Transferfunktion und die Inverse der zweiten Transferfunktion durch ein trainiertes neuronales Netzwerk bzw. allgemeiner einer KI bereitgestellt werden. Die Eingangswerte des neuronalen Netzwerkes sind dabei die Messwerte der Magnetfeldsensoren. Ausgangswerte des neuronalen Netzwerkes sind die Ansteuerkanäle für die Kompensationsspulen. Als Trainingsdaten können dabei mittels der Kalibrierspulen künstliche störende Magnetfelder erzeugt werden. Das Magnetfeld im Bilderfassungsbereich wird, wie bereits beschrieben, beispielsweise mittels einer Sequenzen, wie sie zur Erfassung der "GIRF" genutzt wird, an einem Phantom gemessen. Denkbar wäre auch die Nutzung einer Feldkamera. Der Zielwert ist das ungestörte homogene Magnetfeld B0 des Feldmagneten, oder bei einem kombinierten B0-Shimming ein ideales homogenes Magnetfeld. Die Abweichung des erfassten Magnetfeldes von diesem Zielwert wird dann zur Korrektur der Parameter des neuronalen Netzwerkes mittels Back-Propagation genutzt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Magnetresonanztomographen;
- Fig. 2: eine schematische Darstellung eines beispielhaften Magnetfeldsensors;
- Fig. 3: einen erfindungsgemäßen Magnetresonanztomographen mit einer beispielhaften Anordnung von Magnetfeldsensoren;
- Fig. 4: eine beispielhafte schematische Anordnung von Spulen zum Erzeugen eines Kompensationsfeldes bei einem erfindungsgemäßen Magnetresonanztomographen;
- Fig. 5: einen schematischen Ablaufplan eines beispielhaften erfindungsgemäßen Verfahrens.

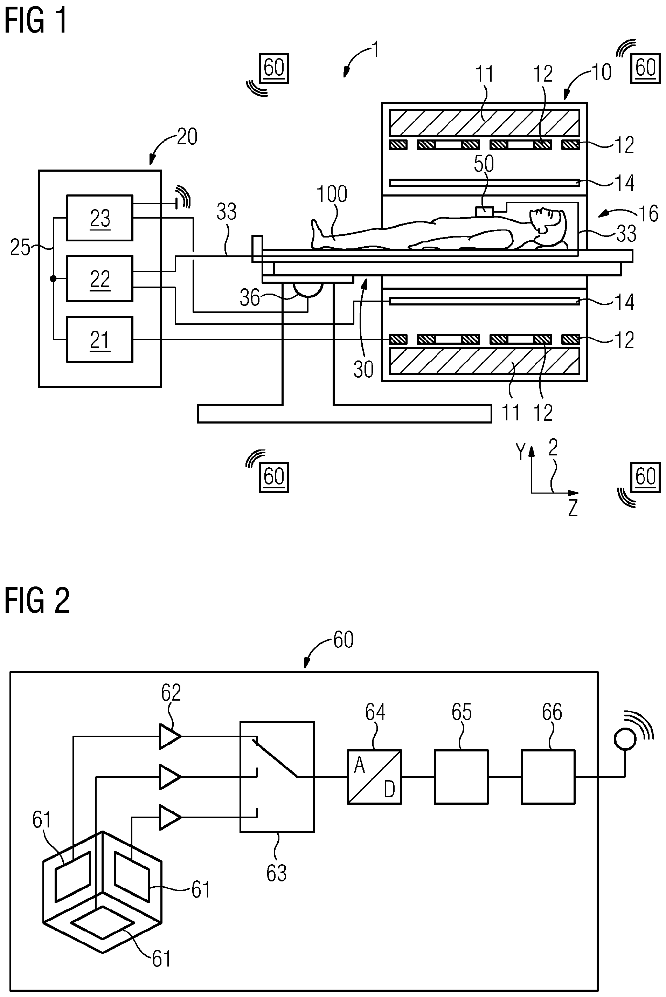

Fig. 1 zeigt eine schematische Darstellung einer Ausführungsform eines Magnetresonanztomographen 1.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Magnetfeldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 zeitlich und räumlich variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Zum Empfang des Magnetresonanzsignals ist eine erfindungsgemäße Lokalspule 50 auf dem Patienten 100 im Patiententunnel 16 angeordnet, um Magnetresonanzsignale aus einem Untersuchungsbereich in unmittelbarer Nähe mit möglichst großem Rauschabstand zu erfassen. Die Lokalspule 50 ist über eine Anschlussleitung 33 mit einem Empfänger in der Hochfrequenzeinheit 22 in Signalverbindung.

Um den Magnetresonanztomographen 1 ist eine Mehrzahl an Magnetfeldsensoren 60 angeordnet. Die Magnetfeldsensoren 60 stehen über eine Signalverbindung, hier als drahtlose Funkverbindung z.B. über WLAN oder Bluetooth angedeutet, mit der Steuerung 23 des Magnetresonanztomographen 1 in Informationsaustausch. Beispielsweise senden die Magnetfeldsensoren 60 eine Information über von ihnen erfassten Magnetfelder aus. Diese Information kann beispielsweise einen Betrag des erfassten Magnetfeldes aufweisen oder den Betrag einer, mehrerer oder aller drei räumlicher Magnetfeldkomponenten. Denkbar ist es, dass die Magnetfeldsensoren 60 diese Information auf Anfrage bzw. Polling der Steuerung 23 senden. Es wäre aber auch möglich, dass die Magnetfeldsensoren 60 diese Information nur in gewissen Abständen senden oder wenn eine Änderung des Magnetfeldes größer einem Schwellwert eingetreten ist.

Die Signalverbindung kann auch leitungsgebunden sein, z.B. über elektrische oder optische Kabel. Die Information kann analog über eine Spannung, Strom oder modulierten Träger übertragen werden oder auch digital.

Die Magnetfeldsensoren 60 sind dabei ausgelegt, Magnetfelder in einer Größenordnung der magnetischen Störfelder zu erfassen und auch aufzulösen, d.h. in dem von dem Magnetfeldsensor 60 ausgegebenen Signal ausreichend für eine Kompensation wiederzugeben. Vorzugsweise beträgt die Auflösung weniger als 5%, 1%, 0,1% oder 0,01% einer maximalen Amplitude eines Störfeldes. Als maximale Amplitude des magnetischen Störfeldes kann mindestens das Magnetfeld der Erde mit typisch 50 Mikrotesla angesehen werden. Als maximale Amplitude können auch die frequenzabhängigen Grenzwerte für niederfrequente Magnetfelder angesehen werden, die bis zu 40 mT gehen können.

Vorzugsweise ist der Magnetfeldsensor 60 bei den zu erwartenden Magnetfeldstärken noch in einem im Wesentlichen linearen Arbeitsbereich. Dies kann zum einen dadurch erreicht werden, indem der Abstand der Magnetfeldsensoren 60 vom Feldmagneten 10 und den Gradientenspulen 12 so groß ist, dass deren Magnetfeld am Ort des Magnetfeldsensors 60 unter der maximalen Amplitude des zu erwartenden magnetischen Störfeldes liegt. Zum anderen sind die Magnetfeldsensoren 60 ausgelegt, bei der maximalen Amplitude des zu erwartenden magnetischen Störfeldes noch nicht in Sättigung zu gehen. Typische Werte für die Stärke der Störfelder liegen zwischen 100 nT und 20000 nT. Vorzugsweise sind die Magnetfeldsensoren 60 in einem Abstand zwischen 1 und 5 m vom Feldmagneten angeordnet.

Fig. 2 zeigt eine schematische Darstellung eines beispielhaften Magnetfeldsensors 60. Beispielhaft werden hier zum Erfassen des Magnetfeldes Hall-Sensoren 61 verwendet, die ein flächiges Halbleiter-Material aufweisen, an das an zwei gegenüberliegenden Seiten der Fläche über erste Kontakte eine Spannung angelegt wird, sodass ein Strom zwischen den Kontakten fließt. Eine Magnetfeldkomponente, die parallel zum Normalenvektor der Fläche durch die Fläche hindurchfließt, verursacht eine Spannung an zweiten Kontakten, die an zwei gegenüberliegenden, quer zur Stromrichtung liegenden Seiten der Fläche abgegriffen wird. Die Spannung ist im Wesentlichen proportional zur Stärke der Magnetfeldkomponente parallel zum Normalenvektor. Mit drei Hall-Sensoren 61, deren Normalenvektoren einen dreidimensionalen Raum aufspannen, vorzugsweise einen kartesischen, kann das Magnetfeld in Richtung und Stärke erfasst werden.

Die abgegriffenen Spannungen der Hall-Sensoren 61 werden durch Verstärker 62 verstärkt und über einen Multiplexer 63 im Zeitmultiplex einem A/D-Wandler 64 zugeführt. In einem Signalprozessor 65 werden die Signale weiter aufbereitet, beispielsweise gefiltert, und für eine Übertragung aufbereitet. Beispielsweise können Datenpakete mit einer Zuordnung der einzelnen Messwerte zu den jeweiligen Hall-Sensoren und damit zur Raumrichtung und einem Zeitbezug bereitgestellt werden. Es ist auch denkbar, dass bereits eine erste Auswertung in Betrag und Richtung erfolgt oder nur jeweils Änderungen des Magnetfeldes erkannt und übertragen werden. Die Datenpakete werden anschließend über eine Hochfrequenzeinheit 66 drahtlos übertragen. Die Übertragung kann beispielsweise nach einem Standard wie Bluetooth oder WLAN erfolgen.

Es sind bezüglich des Magnetfeldsensors unterschiedliche Lösungen im Rahmen der Erfindung denkbar. Beispielsweise können anstelle der Hall-Sensoren 61 andere Magnetfeldsensoren verwendet werden, die beispielsweise auf Mikromechanik/MEMS oder anderen Effekten wie z.B. magnetooptischen oder Quanteneffekten beruhen. Es ist denkbar, dass ein Magnetfeldsensor 60 jeweils nur eine Komponente des Magnetfelds erfasst, dafür aber eine Vielzahl von Magnetfeldsensoren 60 mit unterschiedlichen Ausrichtungen bezüglich des Raumes bzw. des Magnetresonanztomographen verteilt sind. Die Signalübertragung kann auch über ein Kabel, elektrisch oder optisch, erfolgen. Denkbar ist auch eine analoge Übertragung der Signale.

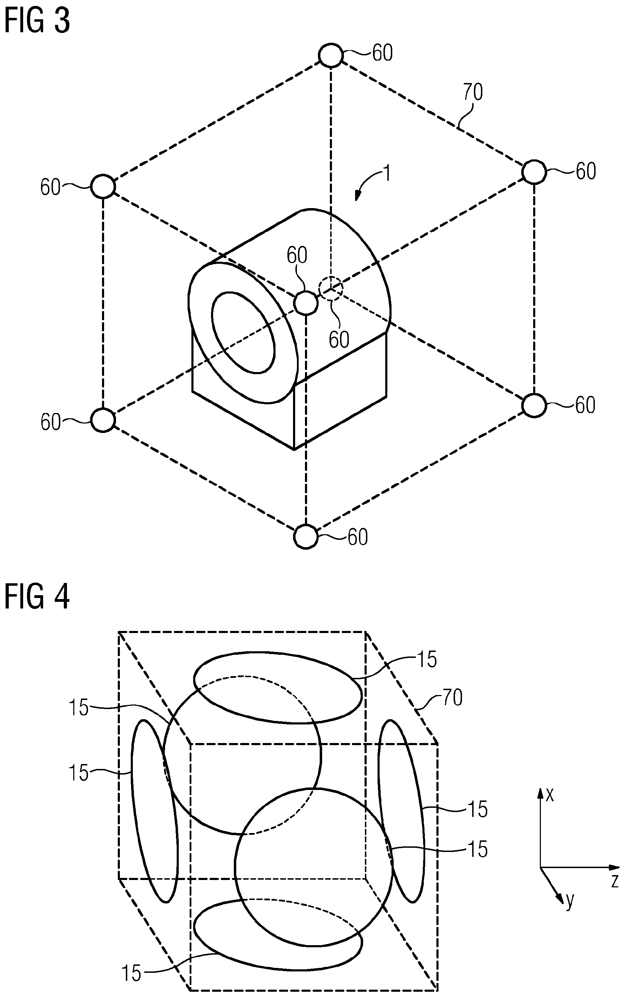

Fig. 3 zeigt eine beispielhafte Anordnung von Magnetfeldsensoren 60 eines erfindungsgemäßen Magnetresonanztomographen 1. Vorzugsweise sind die Magnetfeldsensoren 60 an Ecken eines Polyeders 70 angeordnet, in dessen Innerem sich der Magnetresonanztomograph 1 befindet. Beispielhaft ist hier ein Quader bzw. Würfel dargestellt. Denkbar ist auch ein Tetraeder als einfachster Polyeder oder Polyeder mit mehreren Ecken. Der Polyeder 70 ist dabei nicht notwendigerweise regelmäßig, sondern von den Randbedingungen abhängig. Beispielsweise sind die Magnetfeldsensoren 60 vorzugsweise im gleichen Raum wie der Magnetresonanztomograph 1 angeordnet, sodass der Polyeder 70 in den Raum passen muss. Üblicherweise ist die Deckenhöhe geringer als die Abmessungen in Länge und Breite, sodass der Polyeder 70 sozusagen so flachgedrückt ist, um in den Raum zu passen. Wie bereits zuvor diskutiert, sind die Abstände der Magnetfeldsensoren 60 von dem Feldmagneten 10 und den Gradientenspulen 12 so gewählt, dass die Magnetfeldsensoren 60 nicht durch das Streufeld des Feldmagneten 10 und/oder der Gradientenspulen 12 in Sättigung kommen. Es ist auch denkbar, dass vorbestimmte Eckpunkte nicht mit Magnetfeldsensoren 60 besetzt werden, wenn für die magnetischen Störfelder Randbedingungen wie vorbestimmte Richtungen bzw. Ausschlussrichtungen der Quellen in Bezug zu dem Magnetresonanztomographen 1 vorliegen. Die Anzahl der Magnetfeldsensoren 60 beeinflusst dabei die Güte der der Kompensation. Je genauer ein magnetisches Störfeld durch die Magnetfeldsensoren 60 erfasst wird, desto genauer kann ein resultierendes Störfeld im Bilderfassungsraum mittels der ersten Transferfunktion bestimmt werden. Dabei nimmt auch die Ordnung der Korrektur zu. Mit zwei Magnetfeldsensoren 60 ist ein Gradient eines Störfeldes ermittelbar und entsprechend höhere Ordnungen mit mehr Magnetfeldsensoren 60. Dies entspricht der Korrektur von Magnetfeldern wie Dipolfeld, Quadrupolfeld etc. Begrenzt werden die Möglichkeiten der Kompensation aber auch durch die von den zur Ausgabe von Kompensationsfelder verwendeten Spulen.

In Fig. 4 ist eine beispielhafte Anordnung von Spulen zum Erzeugen eines Kompensationsfeldes dargestellt. Der Bilderfassungsbereich ist dabei innerhalb des Polyeders 70, hier eines Quaders angeordnet. Die Kompensationsspulen 15 sind jeweils paarweise auf gegenüberliegenden Flächen des Polyeders 70 angeordnet und bilden so jeweils Helmholtz-Spulenpaare, mit denen sich jeweils homogene Korrekturfelder in jeder Achsenrichtung x, y und z einstellen lassen sowie durch Beaufschlagung von gegenüberliegenden Spulen mit unterschiedlichen Stromstärken auch Gradienten.

Vorzugsweise werden als Kompensationsspulen 15 die vorhandenen Gradientenspulen 12 verwendet, die üblicherweise bereits ausgelegt sind, jeweils Gradienten in x, y und z-Richtung zu erzeugen. Durch Addition von Kompensationsströmen zu den Strömen, die zur Erzeugung der Gradienten erforderlich sind bzw. in Abschnitten der Sequenz allein durch die Kompensationsströme, können so homogene Magnetfelder und Gradientenfelder zur Kompensation externer Störfelder erzeugt werden. Zusätzliche Spulen, insbesondere zum Erzeugen Magnetfelder höherer Ordnung wie Quadrupolfelder, sind auch denkbar.

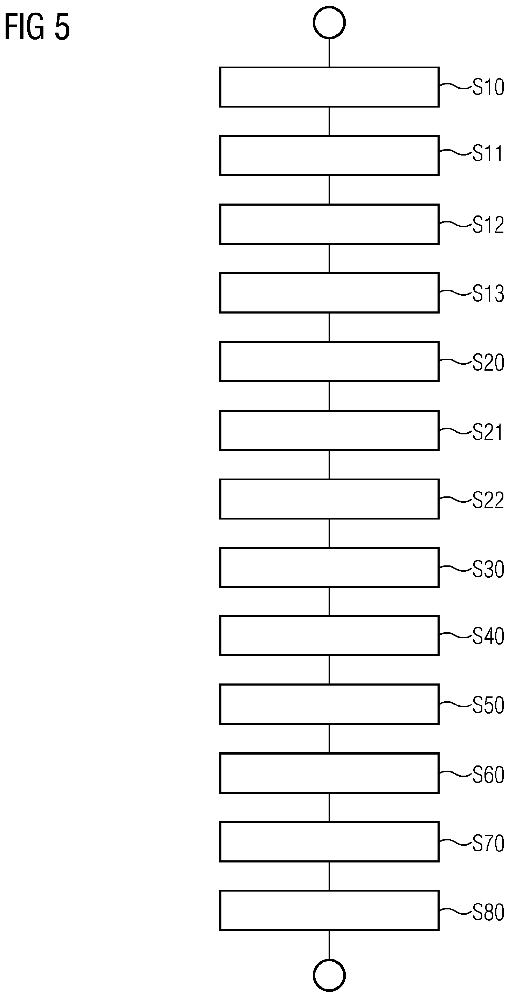

Fig. 5 zeigt einen schematischen Ablaufplan eines beispielhaften erfindungsgemäßen Verfahrens.

In einem Schritt S30 wird von der Steuerung ein Magnetfeld in einer Umgebung des Magnetresonanztomographen 1 mittels der Magnetfeldsensoren 60 erfasst. Denkbar ist beispielsweise, dass die Steuerung 23 die Messwerte der bereits beschriebenen Magnetfeldsensoren 60 in regelmäßigen Abständen abfragt. Die Magnetfeldsensoren 60 können auch selbststätig in vorbestimmten Abständen ihre Messwerte bei der Steuerung 23 abliefern. Denkbar ist auch, dass die Messwertsensoren 60 nur Änderungen des erfassten Magnetfeldes mitteilen. Zu dem Erfassen kann insbesondere auch das Abziehen eines konstanten Anteils bzw. Offsets wie ein Streufeld des Feldmagneten 10 gehören, es ist aber auch denkbar das dies erst in Schritt S40 beim Ermitteln eines Kompensationsfeldes erfolgt. Es ist auch möglich, dass ein Erfassen nur erfolgt, wenn der Magnetresonanztomograph 1 selbst keine zeitlich veränderlichen Störfelder erzeugt, beispielsweise in Phasen von Sequenzen, in denen keine Gradientenfelder von der Steuerung 23 erzeugt werden.

In einem Schritt S40 ermittelt die Steuerung 23 ein Magnetfeld und/oder einen Gradientenfeld-Offset für eine Bilderfassung zur Kompensation des erfassten Magnetfeldes in Abhängigkeit von dem erfassten Magnetfeld. Beispielsweise kann anhand der nachfolgend beschriebenen ersten Transferfunktion aus dem von den Magnetsensoren 60 erfassten Magnetfeld ein störendes Magnetfeld im Bilderfassungsraum ermittelt werden. Zur Kompensation ist dann ein Magnetfeld erforderlich, dass in dem Bilderfassungsbereich bei gleicher Magnetfeldstärke eine umgekehrte Richtung aufweist, sodass sich die Magnetfeldvektoren von störendem Magnetfeld und Kompensationsfeld im Bilderfassungsbereich aufheben. Dabei ist es erforderlich, dass die von dem Feldmagneten 10 und/oder durch Gradientenspulen 12 verursachten Streufelder bereits von dem erfassten Magnetfeld in Schritt S30 abzogen wurden oder dies hier in Schritt S40 erfolgt.

Erfindungsgemäss wird in dem Schritt S40 eine durch das Störfeld verursachte Verschiebung der Mittenfrequenz bzw. veränderte Mittenfrequenz ermittelt. In erster Näherung ist die Larmorfrequenz und damit auch die Mittenfrequenz des Magnetresonanzsignals proportional zum Betrag des Magnetfelds, der Summe aus dem Magnetfeld B0 und dem Störfeld, am Ort des Kernspins und dem magnetischen Moment des Kerns.

In einem Schritt S50 gibt die Steuerung 23 das ermittelte Magnetfeld und/oder den Gradientenfeld-Offset zur Kompensation aus. Dabei steuert die Steuerung 23 die Kompensationsspulen und/oder Gradientenspulen 12 jeweils mit einem Kompensationsstrom an, der das ermittelte Kompensationsfeld im Wesentlichen erzeugt. Dabei ist es grundsätzlich nicht möglich, mit einer begrenzten Anzahl an Kompensationsspulen 15 beliebige Magnetfelder zu erzeugen. Das Ausgeben des Magnetfeldes bzw. der Ströme an die Kompensationsspulen 15 und/oder Gradientenspulen 12 bleibt daher immer eine Näherung und kann beispielsweise durch die Lösung eines Optimierungsproblems gelöst werden, bei dem das störende Magnetfeld in dem Bilderfassungsbereich minimiert wird. Dabei kann eine nachfolgend beschriebene zweite Transferfunktion genutzt werden, die den Zusammenhang zwischen ausgegebenen Kompensationsströmen und den im Bilderfassungsbereich erzeugten Magnetfeldern angibt, bzw. deren Umkehrrelation. Denkbar ist es beispielsweise die Kompensationsströme als Parameter in einem LSR-Verfahren zu variieren, bis ein verbleibendes störendes Magnetfeld im Bilderfassungsbereich minimale Energie hat oder die Feldstärke im gesamten Bilderfassungsbereich unter einem vorbestimmten Schwellwert ist.

Denkbar wäre es auch, ein neuronales Netzwerk mit unterschiedlichen störenden Magnetfeldern zu trainieren, als Ausgabewerte die Kompensationsströme bzw. die veränderte Mittenfrequenz zu liefern, entweder anhand des störenden Magnetfeldes im Bilderfassungsbereich als Eingangsparameter oder direkt mit den von den Magnetfeldsensoren 60 erfassten Magnetfeldwerten. Möglich wäre auch die Nutzung einer künstlichen Intelligenz basierend auf einem anderen Algorithmus bzw. Hardware.

In einem weiteren Schritt S60 erfasst die Steuerung 23 des Magnetresonanztomographen 1 Magnetresonanzdaten für eine Abbildung, wobei das ausgegebene Magnetfeld zumindest während eines Teils der zum Erfassen der Magnetresonanzdaten erforderlichen Sequenz ausgegeben wird. Beispielsweise könnte es vorteilhaft sein, während der Gradienten die Gradientenspulen 12 nicht mit einem Offset zu beaufschlagen, um die maximale Gradientenstärke zu erzielen. Vorzugsweise jedoch erfolgt die gesamte Erfassung der Magnetresonanzdaten mit aktiver Kompensation.

Erfindungsgemäss wird in Schritt S60, mitunter ergänzend zu dem Kompensationsmagnetfeld die veränderte Mittenfrequenz des Magnetresonanzsignals kompensiert. Mit einem variablen Oszillator zum Mischen des Magnetresonanzsignals auf eine Zwischenfrequenz kann beispielsweise die Oszillatorfrequenz durch die Steuerung 23 in Abhängigkeit von dem ermittelten Störfeld so verändert werden, dass die Auswirkung des Störfeldes in den erfassten Magnetresonanzdaten zumindest teilweise kompensiert wird. Ebenso ist es in einer Ausführungsform denkbar, dass das ermittelte Störfeld oder davon abgeleitete Daten, die eine Auswirkung des Störfeldes auf die Magnetresonanzdaten wiedergeben, wie z.B. die Mittenfrequenz, gemeinsam mit den Magnetresonanzdaten in Schritt S60 erfasst und gespeichert werden. So ist es denkbar, diese bei der nachfolgenden Signalverarbeitung und/oder Bildrekonstruktion berücksichtigt werden, um die Auswirkung des Störfeldes in der Abbildung zumindest teilweise zu kompensieren.

Vorzugsweise wird in einem Schritt S70 eine Abbildung aus den erfassten Magnetresonanzdaten rekonstruiert. Dies kann durch die Steuerung 23 erfolgen oder auch durch einen externen dedizierten Rekonstruktionsrechner oder einer Cloud-Ressource.

In einer Ausführungsform ist es dabei denkbar, dass die Bildrekonstruktion in Schritt S70 in Abhängigkeit von den mit den Magnetresonanzdaten erfassten Daten zum Störfeld erfolgt, sodass die Auswirkung des Störfeldes auf die rekonstruierte Abbildung reduziert wird.

In einem Schritt S80 wird die rekonstruierte Abbildung einem Nutzer ausgegeben.

In einer möglichen Ausführungsform des erfindungsgemäßen Verfahrens wird mittels einer Kalibriermessung ein Zusammenhang zwischen den Messwerten der Magnetfeldsensoren 60 eines Kalibrierfeldes und dem davon erzeugten magnetischen Störfeld in dem Bilderfassungsbereich in Form einer ersten Transferfunktion ermittelt.

Dazu wird in einem Schritt S10 ein vorbestimmtes magnetisches Kalibrierfeld mittels einer Kalibrierquelle erzeugt. Die Kalibrierquelle kann beispielsweise eine Stromquelle und eine Spule sein, die von einem Strom der Stromquelle durchflossen wird. Für ring- bzw. kreisförmige Spulen ist beispielsweise das erzeugte Magnetfeld in Abhängigkeit vom Strom wohlbekannt. Die Spule wird an vorbestimmten Orten mit vorbestimmter Ausrichtung angeordnet und mit vorbestimmten Strömen beaufschlagt. Es ist auch denkbar, dass ein niederfrequenter Wechselstrom genutzt wird, beispielsweise um das Feld der Kalibrierspule von anderen Feldern wie dem Erdmagnetfeld oder einem Streufeld des Feldmagneten 11 zu unterscheiden.

Mittels zeitabhängiger Kalibrierfelder kann auch eine frequenzabhängige Abschwächung des störenden Magnetfeldes auf dem Weg in den Bilderfassungsbereich, beispielsweise durch Wirbelströme in der Metallverkleidung, erfasst werden.

In einem Schritt S11 wird dann das von der Kalibrierquelle erzeugte magnetischen Kalibrierfeld mit den Magnetfeldsensoren 60 in einer Umgebung des Magnetresonanztomographen 1 erfasst. Durch eine Modulation mit einem niederfrequenten Wechselstrom kann das Kalibrierfeld mit einem Filter von Hintergrundmagnetfeldern unterschieden werden.

Weiterhin wird in einem Schritt S12 das magnetische Kalibrierfeld in einem Bilderfassungsbereichs mittels einer Kalibriersequenz erfasst, beispielsweise mit einem homogenen Phantom im Bilderfassungsbereich. Zur Erfassung von zeitabhängigen Magnetfeldern kann beispielsweise eine bereits genannte GIRF-Sequenz genutzt werden.

In einem Schritt S13 wird eine erste Transferfunktion ermittelt, die einen Zusammenhang zwischen den von den Magnetfeldsensoren 60 erfassten externen magnetischen Störfeldern und den daraus resultierenden störenden Magnetfeldern im Bilderfassungsbereich bestimmt. Der funktionale Zusammenhang kann beispielsweise eine n x m Matrix sein, der einen linearen Zusammenhang zwischen den Signalen der n Magnetfeldsensoren und m Erfassungspunkten im Bilderfassungsbereich. Durch m wiederholte Messungen mit unterschiedlichen Kalibrierfeldern lassen sich beispielsweise die Koeffizienten der Matrix bestimmen. Es sind auch analytische Methoden denkbar, in denen mittels eines Verfahrens vergleichbar einer Huygens-Box die Felder innerhalb eines von den Magnetfeldsensoren 60 umschlossenen Raums anhand der Felder an der Oberfläche der Hülle der Magnetfeldsensoren 60 ermittelbar ist. Denkbar wäre auch ein neuronales Netzwerk aus n Eingängen und m Ausgängen, das mittels der Kalibriermessungen trainiert wird, das Magnetfeld im Bilderfassungsbereich aus den Messwerten der Magnetfeldsensoren zu bestimmen.

Die ermittelte erste Transferfunktion wird bei der Kompensation dann, wie bereits beschrieben, genutzt, um aus den Messwerten der Magnetfeldsensoren 60 das störende Magnetfeld im Bilderfassungsbereich zu ermitteln bzw. abzuschätzen und anschließend die Ströme für ein Kompensationsfeld zu bestimmen.

Die ermittelte Transferfunktion kann dabei auch Zeit- bzw. Frequenz-abhängig sein.

In einer denkbaren Ausführungsform des erfindungsgemäßen Verfahrens wird eine zweite Transferfunktion bestimmt, die einen funktionalen Zusammenhang zwischen Strömen durch die Kompensationsspule bzw. den Offset-Strömen durch die Gradientenspulen herstellt. Auch hier sind, bei p Kompensationsspulen bzw. an der Kompensation beteiligten Gradientenspulen und q Messpunkten im Bilderfassungsbereich, die mit der bereits beschriebenen Kalibriersequenz erfasst werden, mindestens q wiederholte Messungen mit linear unabhängigen Stromkonfigurationen erforderlich, um die p x q Transfermatrix zu bestimmen. Auch hier ist es wieder denkbar, anstelle eine Matrix zu bestimmen, ein entsprechende neuronales Netzwerk bzw. KI zu trainieren, das bzw. die aus den Kompensationsströmen die erzeugten Magnetfelder im Bilderfassungsbereich abschätzt.

Dazu wird in einem Schritt S20 ein vorbestimmtes Magnetfeld und/oder Gradientenfeld-Offset durch die Steuerung ausgegeben, indem die Kompensationsspulen 15 und/oder Gradientenspulen 12 mit entsprechenden vorbestimmten Strömen von der Steuerung 23 beaufschlagt werden. Anschließend wird in einem Schritt S21 das von der Kompensationsspule 15 und/oder Gradientenfeld-Offsets in den Gradientenspulen 12 erzeugte Magnetfeld in einem Bilderfassungsbereich mittels einer Kalibriersequenz erfasst. Daraus lässt sich dann in einem Schritt S22, wie bereits beschrieben, die zweite Transferfunktion beispielsweise als Matrix oder auch als trainiertes neuronales Netzwerk bestimmen.

Die zweite Transferfunktion kann später beim Bestimmen der Kompensationsströme genützt werden, um die von den Kompensationsströmen hervorgerufenen Magnetfelder zu ermitteln bzw. über eine Umkehrfunktion für ein vorgegebenes Kompensationsfeld die erforderlichen Kompensationsströme.

Da es nur in wenigen Ausnahmefällen ein genaues Matching des störenden Magnetfeldes im Bilderfassungsbereich mit dem von den Kompensationsspulen dort erzeugbaren Kompensationsfeld gibt, sind hier Optimierungsverfahren erforderlich, um die entsprechenden Kompensationsströme zu erzeugen. Denkbar wäre beispielsweise eine Minimierung der Summe der Beträge der Abweichung oder der maximalen Abweichung. Diese Funktion könnte auch durch ein entsprechend trainiertes neuronales Netzwerk oder eine andere künstliche Intelligenz übernommen werden. Denkbar wäre auch ein neuronales Netzwerk, das als Eingabewert die Messwerte der Magnetfeldsensoren 60 nutzt und als Ausgabewert unmittelbar die Vorgaben für die Kompensationsströme liefert. Möglich wäre auch eine Linear Time Invariant-Ansatz, wie er bei GIRF verwendet wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Magnetresonanztomograph, wobei der Magnetresonanztomograph (1) eine Steuerung (23) und eine Mehrzahl an Magnetfeldsensoren (60) aufweist, wobei die Magnetfeldsensoren (60) in einer Umgebung des Magnetresonanztomographen (1) angeordnet sind und ausgelegt sind, niederfrequente Magnetfelder in der Umgebung des Magnetresonanztomographen (1) zu erfassen und über eine Signalverbindung der Steuerung (23) eine Information zu den Magnetfeldern zu übermitteln,
wobei die Steuerung (23) ausgelegt ist, eine Signalverarbeitung bei einer Bilderfassung in Abhängigkeit von der Information zu den Magnetfeldern zu verändern, sodass ein Einfluss des erfassten Magnetfeldes auf die Bilderfassung reduziert wird,
wobei die Steuerung (23) ausgelegt ist,
ein Magnetfeld in einer Umgebung des Magnetresonanztomographen (1) durch die Steuerung (23) mittels der Magnetfeldsensoren (60) zu erfassen und
eine Mittenfrequenz des Magnetresonanzsignals für eine Bilderfassung in Abhängigkeit von dem erfassten Magnetfeld durch die Steuerung (23) zu ermitteln
**dadurch gekennzeichnet, dass**
in einem Empfangspfad ein frequenzvariabler Oszillator zum Heruntermischen des Magnetresonanzsignals auf eine Zwischenfrequenz vorgesehen ist, wobei die Steuerung ausgelegt ist, den frequenzvariablen Oszillator in Abhängigkeit von der ermittelten Mittenfrequenz im Bilderfassungsbereich so einzustellen, dass das heruntergemischte Magnetresonanzsignal eine konstante Mittenfrequenz aufweist und so der Effekt des störenden Magnetfeldes kompensiert wird.

2. Magnetresonanztomograph nach Anspruch 1, wobei die Steuerung (23) ausgelegt ist, ein quasistatisches Magnetfeld und/oder ein Gradientenfeld bei einer Bilderfassung in Abhängigkeit von der Information zu den Magnetfeldern zu verändern, sodass ein Einfluss des erfassten Magnetfeldes auf die Bilderfassung reduziert wird.

3. Magnetresonanztomograph nach einem der vorhergehenden Ansprüche, wobei die Magnetfeldsensoren (60) einen Halbleitersensor aufweisen.

4. Magnetresonanztomograph nach Anspruch 3, wobei die Magnetfeldsensoren (60) ausgelegt sind, eine Magnetfeldrichtung zu erfassen.

5. Verfahren zum Betrieb eines Magnetresonanztomographen (1), wobei der Magnetresonanztomograph (1) eine Steuerung (23) und eine Mehrzahl an Magnetfeldsensoren (60) aufweist, wobei die Magnetfeldsensoren (60) in einer Umgebung des Magnetresonanztomographen (1) angeordnet sind und ausgelegt sind, niederfrequente Magnetfelder in der Umgebung des Magnetresonanztomographen (1) zu erfassen und über eine Signalverbindung der Steuerung (23) eine Information zu den Magnetfeldern zu übermitteln,
wobei das Verfahren die Schritte aufweist:
(S30) Erfassen eines Magnetfelds in einer Umgebung des Magnetresonanztomographen (1) durch die Steuerung (23) mittels der Magnetfeldsensoren (60);
(S40) Ermitteln einer Mittenfrequenz des Magnetresonanzsignals für eine Bilderfassung in Abhängigkeit von dem erfassten Magnetfeld durch die Steuerung (23);
(S60) Erfassen von Magnetresonanzdaten für eine Bildgebung in Abhängigkeit von der Mittenfrequenz,
**dadurch gekennzeichnet, dass**
in einem Empfangspfad ein frequenzvariabler Oszillator zum Heruntermischen des Magnetresonanzsignals auf eine Zwischenfrequenz vorgesehen ist, wobei die Steuerung den frequenzvariablen Oszillator in Abhängigkeit von der ermittelten Mittenfrequenz im Bilderfassungsbereich so einstellt, dass das heruntergemischte Magnetresonanzsignal eine konstante Mittenfrequenz aufweist und so der Effekt des störenden Magnetfeldes kompensiert wird.

6. Verfahren nach Anspruch 5, wobei das Verfahren weiterhin die Schritte aufweist:
(S70) Rekonstruieren einer Abbildung aus den erfassten Magnetresonanzdaten;
(S80) Ausgeben der Abbildung an einen Nutzer.

7. Verfahren nach einem der Ansprüche 5 oder 6 wobei das Verfahren weiterhin die Schritte aufweist:
(S10) Ausgeben eines vorbestimmten magnetischen Kalibrierfeldes mittels einer Kalibrierquelle;
(S11) Erfassen des magnetischen Kalibrierfeldes mit den Magnetfeldsensoren (60) in einer Umgebung des Magnetresonanztomographen (1);
(S12) Erfassen des magnetischen Kalibrierfeldes in einem Bilderfassungsbereichs mittels einer Kalibriersequenz durch die Steuerung (23);
(S13) Ermitteln einer ersten Transferfunktion für ein Magnetfeld zwischen den Magnetfeldsensoren und dem Bilderfassungsbereich,
wobei in dem Schritt (S40) Ermitteln einer Mittenfrequenz und/oder eines quasistatischen Magnetfeldes und/oder Gradientenfeld-Offsets das Ermitteln in Abhängigkeit von der ersten Transferfunktion erfolgt.

8. Verfahren nach einem der Ansprüche 5 bis 7, wobei das Verfahren weiterhin die Schritte aufweist:
(S20) Ausgeben eines vorbestimmten Magnetfeldes und/oder Gradientenfeld-Offsets durch die Steuerung (23);
(S21) Erfassen des vorbestimmten Magnetfeldes und/oder Gradientenfeld-Offsets in einem Bilderfassungsbereichs mittels einer Kalibriersequenz;
(S22) Ermitteln einer zweiten Transferfunktion für das Magnetfeld und/oder den Gradientenfeld-Offset und dem Bilderfassungsbereich;
wobei in dem Schritt (S40) Ermitteln eines quasistatischen Magnetfeldes und/oder Gradientenfeld-Offsets das Ermitteln in Abhängigkeit von der zweiten Transferfunktion erfolgt.

9. Verfahren nach Anspruch 7 oder 8, wobei die Schritte Ermitteln einer ersten Transferfunktion und/oder Ermitteln einer zweiten Transferfunktion durch das Trainieren eines neuronalen Netzwerkes ausgeführt werden,
wobei Eingangswerte des neuronalen Netzwerkes Messwerte der Magnetfeldsensoren sind und Ausgangswerte des neuronalen Netzwerkes die Ansteuerkanäle für die Kompensationsspulen, wobei als Trainingsdaten mittels Kalibrierspulen künstliche störende Magnetfelder erzeugt werden.

10. Computerprogrammprodukt, welches in eine Speichereinheit einer Steuerung (23) eines Magnetresonanztomographen (1) nach Anspruch 1 ladbar ist, aufweisend Programmcode-Mittel, um ein Verfahren nach einem der Ansprüche 5 bis 9 auszuführen, wenn das Computerprogrammprodukt in der Steuerung (23) des Magnetresonanztomographen (1) nach Anspruch 1 ausgeführt wird.

11. Computer-lesbares Medium, auf dem Programmcode-Mittel gespeichert sind, die von einer Steuerung (23) eines Magnetresonanztomographen (1) nach Anspruch 1 gelesen werden können und von der Steuerung (23) ausgeführt werden können, um ein Verfahren nach einem der Ansprüche 5 bis 9 auszuführen.

## Claims

1. Magnetic resonance tomography unit, wherein the magnetic resonance tomography unit (1) comprises a controller (23) and a plurality of magnetic field sensors (60), wherein the magnetic field sensors (60) are arranged in an environment of the magnetic resonance tomography unit (1) and are embodied to capture low-frequency magnetic fields in the environment of the magnetic resonance tomography unit (1) and to transmit information about the magnetic fields to the controller (23) via a signal connection,
wherein the controller (23) is embodied to change signal processing during image capture in dependence on the information about the magnetic fields so that an influence of the captured magnetic field on image capture is reduced, wherein the controller (23) is embodied
to capture a magnetic field in an environment of the magnetic resonance tomography unit (1) by way of the controller (23) by means of the magnetic field sensors (60) and
to ascertain a centre frequency of the magnetic resonance signal for image capture in dependence on the captured magnetic field by way of the controller (23)
**characterised in that**
a variable-frequency oscillator is provided in the receive path to down-mix the magnetic resonance signal to an intermediate frequency, wherein the controller is embodied to set the variable-frequency oscillator in dependence on the ascertained centre frequency in the image capturing region such that the down-mixed magnetic resonance signal has a constant centre frequency and thus the effect of the interfering magnetic field is compensated.

2. Magnetic resonance tomography unit according to claim 1, wherein the controller (23) is embodied to change a quasistatic magnetic field and/or a gradient field during image capture in dependence on the information about the magnetic fields so that the influence of the captured magnetic field on image capture is reduced.

3. Magnetic resonance tomography unit according to one of the preceding claims, wherein the magnetic field sensors (60) comprise a semiconductor sensor.

4. Magnetic resonance tomography unit according to claim 3, wherein the magnetic field sensors (60) are embodied to capture a magnetic field direction.

5. Method for operating a magnetic resonance tomography unit (1), wherein the magnetic resonance tomography unit (1) comprises a controller (23) and a plurality of magnetic field sensors (60), wherein the magnetic field sensors (60) are arranged in an environment of the magnetic resonance tomography unit (1) and embodied to capture low-frequency magnetic fields in the environment of the magnetic resonance tomography unit (1) and to transmit information about the magnetic fields to the controller (23) via a signal connection,
wherein the method comprises the steps:
(S30) capturing a magnetic field in an environment of the magnetic resonance tomography unit (1) by way of the controller (23) by means of the magnetic field sensors (60);
(S40) ascertaining a centre frequency of the magnetic resonance signal for image capture in dependence on the captured magnetic field by way of the controller (23) (S60) ascertaining magnetic resonance data for imaging in dependence on the centre frequency,
**characterised in that**
a variable-frequency oscillator is provided in a receive path to down-mix the magnetic resonance signal to an intermediate frequency, wherein the controller sets the variable-frequency oscillator in dependence on the ascertained centre frequency in the image capturing region such that the down-mixed magnetic resonance signal has a constant centre frequency and thus the effect of the interfering magnetic field is compensated.

6. Method according to claim **5,** wherein the method furthermore comprises the steps:
(S70) reconstructing mapping from the captured magnetic resonance data;
(S80) outputting the mapping to a user.

7. Method according to one of claims 5 or 6, wherein the method furthermore comprises the steps:
(S10) outputting a predetermined magnetic calibration field by means of a calibration source;
(S11) capturing the magnetic calibration field with the magnetic field sensors (60) in an environment of the magnetic resonance tomography unit (1);
(S12) capturing the magnetic calibration field in an image capturing region by means of a calibration sequence by way of the controller (23);
(S13) ascertaining a first transfer function for a magnetic field between the magnetic field sensors and the image capturing region,
wherein, in the step (S40) of ascertaining a centre frequency and/or a quasistatic magnetic field and/or gradient field offset, the ascertaining takes place in dependence on the first transfer function.

8. Method according to one of claims 5 to 7, wherein the method furthermore comprises the steps:
(S20) outputting a predetermined magnetic field and/or gradient field offset by way of the controller (23);
(S21) capturing the predetermined magnetic field and/or gradient field offset in an image capturing region by means of a calibration sequence;
(S22) ascertaining a second transfer function for the magnetic field and/or the gradient field offset and the image capturing region;
wherein, in the step (S40) of ascertaining a quasistatic magnetic field and/or gradient field offset, the ascertaining takes place in dependence on the second transfer function.

9. Method according to claim 7 or 8, wherein the steps of ascertaining a first transfer function and/or ascertaining a second transfer function are executed by training a neural network,
wherein input values of the neural network are measured values of the magnetic field sensors and output values of the neural network are the actuation channels for the compensation coils, wherein artificial interfering magnetic fields can be generated as training data by means of the calibration coils.

10. Computer program product, which can be loaded into a memory unit of a controller (23) of a magnetic resonance tomography unit (1) according to claim 1, comprising program code means for executing a method according to one of claims 5 to 9 when the computer program product is executed in the controller (23) of the magnetic resonance tomography unit (1) according to claim 1.

11. Computer-readable medium on which program code means are stored which can be read by a controller (23) of a magnetic resonance tomography unit (1) according to claim 1 and can be executed by the controller (23) in order to execute a method according to one of claims 5 to 9.

## Revendications

1. Tomodensitomètre à résonnance magnétique, dans lequel le tomodensitomètre (1) à résonnance magnétique a une commande (23) et une pluralité de capteurs (60) de champ magnétique, dans lequel les capteurs (60) de champ magnétique sont disposés dans un environnement du tomodensitomètre (1) à résonnance magnétique et sont conçus pour détecter des champs magnétiques de fréquence basse dans l'environnement du tomodensitomètre (1) à résonnance magnétique et pour, en passant par une liaison de signal, transmettre une information sur les champs magnétiques à la commande (23),
dans lequel la commande (23) est conçue pour modifier un traitement du signal, lors d'une prise d'image, en fonction de l'information sur les champs magnétiques, de manière à réduire l'influence du champ magnétique détecté sur la prise d'image,
dans lequel la commande (23) est conçue,
pour détecter, au moyen des capteurs (60) de champ magnétique par la commande (23), un champ magnétique dans un environnement du tomodensitomètre (1) à résonnance magnétique et pour déterminer, par la commande (23), en fonction du champ magnétique détecté, une fréquence moyenne du signal de résonnance magnétique pour une prise d'image,
**caractérisé en ce qu'**
il est prévu, dans un chemin de réception, un oscillateur variable en fréquence pour abaisser par mélange le signal de résonnance magnétique à une fréquence intermédiaire, dans lequel la commande est conçue pour régler l'oscillateur variable en fréquence en fonction de la fréquence moyenne détectée dans la plage de prise d'image, de manière à ce que le signal de résonnance magnétique abaissé par mélange ait une fréquence moyenne constante et à compenser ainsi l'effet du champ magnétique parasite.

2. Tomodensitomètre à résonnance magnétique suivant la revendication 1, dans lequel la commande (23) est conçue pour modifier un champ magnétique quasi-statique et/ou un champ de gradient lors d'une prise d'image en fonction de l'information sur les champs magnétiques, de manière à réduire une influence du champ magnétique détecté sur la prise d'image.

3. Tomodensitomètre à résonnance magnétique suivant l'une des revendications précédentes, dans lequel les capteurs (60) de champ magnétique ont un capteur à semiconducteur.

4. Tomodensitomètre à résonnance magnétique suivant la revendication 3, dans lequel les capteurs (60) de champ magnétique sont conçus pour détecter une direction du champ magnétique.

5. Procédé pour faire fonctionner un tomodensitomètre (1) à résonnance magnétique,
dans lequel le tomodensitomètre (1) à résonnance magnétique a une commande (23) et une pluralité de capteurs (60) de champ magnétique, dans lequel les capteurs (60) de champ magnétique sont disposés dans un environnement du tomodensitomètre (1) à résonnance magnétique et sont conçus pour détecter des champs magnétiques de fréquence basse dans l'environnement du tomodensitomètre (1) à résonnance magnétique et pour, en passant par une liaison de signal, transmettre une information sur les champs magnétiques à la commande (23),
dans lequel le procédé comprend les stades :
(S30) détection d'un champ magnétique dans un environnement du tomodensitomètre (1) à résonnance magnétique par la commande (23) au moyen des capteurs (60) de champ magnétique ;
(S40) détermination, par la commande (23), d'une fréquence moyenne du signal de résonnance magnétique pour une prise d'image en fonction du champ magnétique détecté ;
(S60) saisie des données de résonnance magnétique pour une imagerie en fonction de la fréquence moyenne,
**caractérisé en ce que**,
dans un chemin de réception, il est prévu un oscillateur variable en fréquence d'abaissement par mélange du signal de résonnance magnétique à une fréquence intermédiaire, dans lequel la commande règle l'oscillateur variable à fréquence en fonction de la fréquence moyenne déterminée dans la partie de prise d'image, de manière à ce que le signal de résonnance magnétique abaissé par mélange ait une fréquence moyenne constante et à compenser ainsi l'effet du champ magnétique parasite.

6. Procédé suivant la revendication 5, dans lequel le procédé comporte en outre les stades :
(S70) reconstruction d'une représentation à partir des données de résonnance magnétique saisies ;
(S80) envoi de la représentation à un utilisateur.

7. Procédé suivant l'une des revendications 5 ou 6, dans lequel le procédé comprend en outre les stades :
(S10) émission d'un champ d'étalonnage magnétique déterminé à l'avance au moyen d'une source d'étalonnage ;
(S11) détection du champ d'étalonnage magnétique par les capteurs (60) de champ magnétique dans un environnement du tomodensitomètre (1) à résonnance magnétique ;
(S12) détection du champ d'étalonnage magnétique dans une partie de prise d'image au moyen d'une séquence d'étalonnage par la commande (23) ;
(S13) détermination d'une première fonction de transfert pour un champ magnétique entre les capteurs de champ magnétique et la partie de prise d'image,
dans lequel, dans le stade (S40) détermination d'une fréquence moyenne et/ou d'un champ magnétique quasi-statique et/ou d'un décalage de champ de gradient, la détermination s'effectue en fonction de la première fonction de transfert.

8. Procédé suivant l'une des revendications 5 à 7, dans lequel le procédé comprend en outre les stades :
(S20) émission d'un champ magnétique déterminé à l'avance et/ou d'un décalage de champ de gradient par la commande (23) ;
(S21) détection du champ magnétique déterminé à l'avance et/ou du décalage du champ de gradient dans une partie de prise d'image au moyen d'une séquence d'étalonnage ;
(S22) détermination d'une deuxième fonction de transfert pour le champ magnétique et/ou le décalage de champ de gradient et la partie de prise d'image ;
dans lequel, dans le stade (S40) détermination d'un champ magnétique quasi-statique et/ou d'un décalage de champ de gradient, la détermination s'effectue en fonction de la deuxième fonction de transfert.

9. Procédé suivant la revendication 7 ou 8, dans lequel les stades détermination d'une première fonction de transfert et/ou détermination d'une deuxième fonction de transfert sont exécutés par l'entraînement d'un réseau neuronal,
dans lequel des valeurs d'entrée du réseau neuronal sont des valeurs de mesure des capteurs de champ magnétique et des valeurs de sortie du réseau neuronal sont les canaux de commande des bobines de compensation, dans lequel on produit, comme données d'entraînement au moyen de bobines d'étalonnage, des champs magnétiques parasites artificiels.

10. Produit de programme d'ordinateur, qui peut être chargé dans une unité de mémoire d'une commande (23) d'un tomodensitomètre (1) à résonnance magnétique suivant la revendication 1, comportant des moyens de code de programme pour exécuter un procédé suivant l'une des revendications 5 à 9, lorsque le produit de programme d'ordinateur est exécuté dans la commande (23) du tomodensitomètre (1) à résonnance magnétique suivant la revendication 1.

11. Support, déchiffrable par ordinateur, sur lequel sont mis en mémoire des moyens de code de programme, qui peuvent être déchiffrés par une commande (23) d'un tomodensitomètre (1) à résonnance magnétique suivant la revendication 1 et qui peuvent être exécutés par la commande (23), afin d'exécuter un procédé suivant l'une des revendications 5 à 9.
